Europäisches Patentamt

(19) European Patent Office

Office européen des brevets

(11) Publication number : **0 471 080 B1**

(12) # EUROPEAN PATENT SPECIFICATION

(45) Date of publication of patent specification :
06.09.95 Bulletin 95/36

(51) Int. Cl.⁶ : **H01C 17/12,** C23C 14/34,
B41J 2/335

(21) Application number : **91903659.0**

(22) Date of filing : **31.01.91**

(86) International application number :
PCT/JP91/00119

(87) International publication number :
WO 91/11328 08.08.91 Gazette 91/18

(54) SPUTTERING TARGET, FILM RESISTOR FORMED WITH THE USE THEREOF, AND THERMAL PRINTER HEAD AND ASSOCIATED METHODS OF PRODUCTION.

(30) Priority : **01.02.90 JP 20446/90**
**18.10.90 JP 277777/90**

(43) Date of publication of application :
19.02.92 Bulletin 92/08

(45) Publication of the grant of the patent :
06.09.95 Bulletin 95/36

(84) Designated Contracting States :
DE FR GB

(56) References cited :
JP-A-62 238 767
US-A- 4 663 120
PATENT ABSTRACTS OF JAPAN vol. 013, no. 227 (C-600)25 May 1989
WORLD PATENTS INDEX Section Ch, Week 7933, Derwent Publications Ltd., London,GB; Class L, AN 79-60948B
WORLD PATENTS INDEX Section Ch, Week 7543, Derwent Publications Ltd., London,GB; Class L, AN 75-71385W
WORLD PATENTS INDEX Section Ch, Week 7845, Derwent Publications Ltd., London,GB; Class G, AN 78-81039A

(73) Proprietor : **KABUSHIKI KAISHA TOSHIBA**
**72, Horikawa-cho,**
**Saiwai-ku**
**Kawasaki-shi, Kanagawa-ken 210, Tokyo (JP)**

(72) Inventor : **ISHIGAMI, Takashi**
**2000-16-1212, Kosugaya-cho,**
**Sakae-ku**
**Yokohama-shi, Kanagawa 247 (JP)**
Inventor : **KAWAI, Mitsuo**
**1-27-10, Shimoseya,**
**Seya-ku**
**Yokohama-shi, Kanagawa 246 (JP)**
Inventor : **IIDA, Atsuko**
**1070, Kamariya,**
**Kanazawa-ku**
**Yokohama-shi, Kanagawa 236 (JP)**

(74) Representative : **Freed, Arthur Woolf et al**
**MARKS & CLERK,**
**57-60 Lincoln's Inn Fields**
**London WC2A 3LS (GB)**

## Description

This invention relates to a sputtering target capable of forming easily and uniformly a film resistor having high specific resistance, excellent heat resistance, and anti-corrosion property, and a film resistor using such a sputtering target and a thermal printer head using such a film resistor. From JP-A-53 113 554 a thin film thermal head is known, the resistor of which contains niobium as a metal element and silicon oxide as an electric insulating material. A sputtering target containing a niobium silicide is known from JP-A-1 039 374.

A thermographic type recording apparatus using a thermal printer head was used as a recording apparatus provided in a facsimile, a copier or a ticket vender with advantages such as a low noise and less maintenance and so forth. In the aforementioned thermal printer head, tantalum nitride has been used hitherto as a stable material for a film resistor fusing a printing medium. The Ta-N type film is produced by reactive sputtering a Ta target in a nitrogen environment and although the specific resistance becomes larger as the nitrogen content is increased, $Ta_2N$ has been generally used as a heat generator because of the reliability and stability.

However, $Ta_2N$ itself has specific resistance of approximately 200 $\mu\Omega$cm and even if the thickness of the film is made very thin and fine to increase the specific resistance, there is a limit in the maximum value. For example, to obtain the resistance of 200 $\Omega$ using $Ta_2N$, it is necessary to form a strip shape with 2:1 in the ratio of length and width and thickness of approximately 20 nm. When making such thin film, the control of thickness is very difficult and the reproducibility and uniformity of the film decreases, and consequently the film is easy to damage by increasing the power density.

To improve the defects aforementioned, an idea of forming a film resistor to be meander type and increasing the effective length per unit area thereby to increase the resistance was proposed. However, as the resolution of thermal printer head increase, more high technology for patterning is required and it results in the lowering of the yield. Furthermore, in the manufacturing process, a reactive sputtering method is used wherein the amount of gas introduced into the vacuum reactor is very small and for controlling of the introduction an exact management technology is required.

On the other hand, Japanese Patent Application Laid-open No. SHO 52(1977)-109947 discloses that high specific resistance film is obtained by using a target where a hollow of a quartz disc is filled with a heat generating resistor such as TiC. Though the film has excellent anti-oxidizability at a high temperature, the control of the composition of the film is difficult and the fluctuation of sheet resistance in the substrate is large.

An application of a thin thermet film to obtain high specific resistance can be proposed. As a thermet film, a $Ta-SiO_2$ resistor film and the like is used and it has been made by, e.g., a multi source sputtering method using, for example, both a Ta target and a $SiO_2$ target. However, since the sputtering angles of Ta and Si differ greatly, the compositions of the $Ta-SiO_2$ resistor film and the target deviate from each other due to a slight change of sputtering conditions and the control of the composition of the film is difficult. Because of the aforementioned reasons the composition of the film tends not to be uniform and it results in undesirable large fluctuation of the sheet resistance and less reproducibility.

An object of the present invention is, considering the points mentioned above, to provide a sputtering target which is capable of forming a high specific resistant film with an uniform composition, which is the almost same as that from that of the target. Another object of the present invention is to provide a film resistor with high specific resistance, and excellent heat resistance and anti-corrosion property under controlling the fluctuation of the sheet resistance in the film. Furthermore, the other object is to provide a thermal printer head capable of high speed operation and so forth and improving the resolution of printed images, using the aforementioned film resistor.

From the results of examination of a film resistor of a thermal printer head to be used as a heat generator and so forth, the indenters have found that a $Nb-SiO_2$ type film resistor shows high resistance with excellent heat resistivity and anti-corrosion property, and that the reproducibility of the film composition of the aforementioned $Nb-SiO_2$ type film resistor is improved remarkably by using a silicon oxide type compound target containing Nb as its oxide or silicide.

A sputtering target of the present invention is made based on the aforementioned information and comprises a sintered body containing an oxide containing niobium, a silicide containing niobium, and silicone oxide substantially for the rest.

The film resistor of the present invention is characterized by forming by sputtering using the aforementioned sputtering target

Further, the thermal printer head of the present invention comprises an insulating substrate; many heat generating resistors disposed thereon; and an electrode connected with the heat generating resistors; wherein the heat generating resistors comprises a film resistor formed by using the aforementioned sputtering target.

The sputtering target of the present invention comprises, as mentioned above, niobium as a metal component which is the main component of a target, in detail, as a form of oxide and silicide of niobium. Since sput-

2

tering emitting angles of Nb and Si are close, the sputtered film with less deviation in the composition from that of the target is obtainable. And also since a target of the present invention comprises niobium as a compound of oxide or silicide dispersed uniformly in the target, it enables to obtain a film possessing an uniform film composition.

The aforementioned sputtering target of the present invention is obtainable by reactive sintering the mixture of powder of niobium or niobium alloy and powder of silicon oxide. In the mixture of powders as above, the ratio of powder of silicon oxide is preferable in the range of 15 mol % to 70 mol %. Namely, preferably, the sputtering target of the present invention is obtained by reactive sintering the powder of niobium or niobium alloy containing silicon oxide in the range of 15 mol % to 70 mole %.

Further, the reason that mole ratio of silicon oxide in the mixture of the powders is given to be in the rage of 15 mol % to 70 mol % is as follows. When the mole ratio of silicon oxide powder exceeds 70 mol %, the sintered body obtained becomes brittle and it entails the workability poor. Furthermore, the uniformity of a sputtered film formed is lowered and since the change of resistance in the course of the sputtering increases it renders the exact control of resistance of the film sputtered difficult and results in a large fluctuation of sheet resistance. On the other hand, when the mole ratio of silicon oxide in the mixture is less than 15 mol %, the specific resistance of a sputtered film obtained is lowered and the function as a resistor decreases. The more preferable mole ratio of the silicon oxide in the aforementioned powder mixture is in the range of 30 to 60 mole %.

Still further, the sputtering target of the present invention is also obtainable by sintering the mixture of powder comprising powdery oxide of niobium or niobium alloy, powdery silicide of niobium or niobium alloy and powdery silicon oxide. In this case the ratio of each powder is not limited to a special value but it is preferably decided referring to the mixture of powders for the reactive sintering as mentioned above.

As a method of sintering of the powder mixture, a hot press method is generally used. After hot isostatic pressing (HIP) or cold isostatic pressing (CIP), sintering at a normal pressure may be conducted.

The starting material of niobium is not limited to powdery niobium and powdery niobium alloy is usable as mentioned above. As a niobium alloy, Nb-Ta alloy or Nb-Fe may be used. Since both niobium and tantalum consist often in the same natural ore in various ratios, an alloy comprising both metals is beneficial from the point of view of the cost and acquisition. Using such niobium alloy powder, the target obtained comprises niobium as a double oxide or double silicide of tantalum and/or iron. Also using the target comprising niobium in the aforementioned form, the same effect as the above is obtained.

The film resistor of the present invention is made of a film formed by sputtering using the above sputtering target and basically has Nb-SiO$_2$ type composition. The film itself is mainly amorphous and thereby exhibits excellent antioxidizing and heat resistent properties. The aforementioned niobium component may exist as the form of Nb-Ta alloy or Nb-Fe alloy. The aforementioned film resistor is preferably a thin film having thickness of 5 nm to 3000 nm. The more preferable thickness is in the range of 50 nm to 200 nm and more preferable is in the range of 80 nm to 500 nm.

Thus, a film resistor containing silicon oxide as a resistor component and mainly niobium as a metal component exhibits high specific resistance together with excellent heat resistance and anticorrosion properties. It is used as a heat generator of a thermal head printer to generate a large and stable amount of heat, thus allowing the excellent printing record. The density of niobium is approximately a half that of tantalum and the cost per unit weight is also approximately a half that of tantalum. Therefore from the view of cost reduction, it is very advantageous. Since the film resistor of the present invention is produced by using the sputtering target possessing excellent sputtering characteristics ( e.g. sputtering emission angle, uniformity in composition and so forth), satisfactory adhesiveness to a substrate is obtained and good reproducibility and uniformity of the composition of the film is also attained because of less deviation in the composition of the film from that of the target. Thus, high specific resistance is realized constantly and fluctuation of sheet resistance is reduced remarkably.

In the case of using the film resistor of the present invention as a heat generator, the film resistor is required to have high specific resistance, which is preferable to be in the range of $10^2$ $\mu\Omega$ cm to $10^6$ $\mu\Omega$ cm. The film resistor having such high specific resistance has obtained constantly by the use of the sputtering target of the present invention. The film resistor having the specific resistance less than $10^2$ $\mu\Omega$ cm can not function as a film resistor having high specific resistance. On the other hand, when the specific resistance exceeds $10^6$ $\mu\Omega$cm, the specific resistance of the film depends on the mole ratio of silicon oxide contained in the target and as increasing the ratio of the silicon oxide in the spattering target, the sintered target becomes brittle and the stability in the resistance of the film obtained becomes lower. The preferred range of the specific resistance is in the range of $3 \times 10^2$ $\mu\Omega$cm to $6 \times 10^5$ $\mu\Omega$cm, and more preferably in the range of $3 \times 10^3$ $\mu\Omega$cm to $6 \times 10^4$ $\mu\Omega$cm. The term "specific resistance" means the value obtained by multiplying sheet resistance by film thickness.

EP 0 471 080 B1

To provide the film resistor having constantly stable and high specific resistance, the low fluctuation of sheet resistance is required. In the film resistor of the present invention, by mainly using niobium as a metal component and at the same time by the use of the sputtering target of the present invention having the uniform film composition, it is possible to repress the fluctuation of sheet resistance to be 20 % or less. If a film having large fluctuation of sheet resistance is used in a thermal printer head, the fluctuation in the amount of heat generated in a substrate will become larger and degrade printing characteristics. It is more desirable that the fluctuation of the sheet resistance is 10 % or less.

The aforementioned term "sheet resistance" is the value defined by the following formula.

$$\frac{MA - MI}{AV} \times 100(\%)$$

wherein MA is the maximum value of resistance, MI is the minimum value of resistance, and AV is the average value of resistance.

The fluctuation of sheet resistance as above is measured by CD four proves method (the apparatus used; RESISTEST-8A, made in Napson KK.) on the measuring points (shown as x) as shown in Fig. 5. These measuring points are put on the centers of as many complete 5 mm squares as possible divided on the area of a film on a substrate A.

The thermal printer head of the present invention uses the film resistor having the aforementioned characteristics as a heat generator, thus responding to high speed printing and high temperature resistivity and possessing good stability and high resolution of printing.

Fig. 1 is a graph showing the relation between the amount of $SiO_2$ in the target used and the film resistance of a $Nb-SiO_2$ type film resistor produced in an example according to the present invention, comparing to that of a conventional $Ta-SiO_2$ type film resistor.

Fig. 2 is a graph showing the relation between the position on a substrate and the specific resistance of a $Nb-SiO_2$ type film resistor produced in an example according to the present invention, comparing to that of a conventional $Ta-SiO_2$ type film resistor.

Fig. 3 is a sectional view schematically showing the structure of a thermal printer head of an example according to the present invention.

Fig. 4. is a graph showing the change percentage of resistance when a heating pulse is applied to a thermal printer head using a $Nb-SiO_2$ type film resistor as a heat generator, the $Nb-SiO_2$ type film resistor produced in an example according to the present invention, comparing to that of a conventional thermal printer head.

Fig. 5 shows the points of measuring sheet resistance on a substrate.

Now, this invention will be described below in more detail with examples.

Example 1

Powder of Nb with an average particle size of 3 $\mu$m and powder of silicon oxide fully dried with an average particle size of 1 $\mu$m were weighed out so that the ratio of $Nb/SiO_x$ was 70/30 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 300 W, Ar flow rate of 17 sccm and gas pressure of 5.3 mTorr to 5.5 mTorr, a film of 100 nm in thickness was formed on a glazed alumina substrate of 3 inches in size.

Example 2

Powder of Nb with an average particle size of 3 $\mu$m and powder of silicon oxide fully dried with an average particle size of 1 $\mu$m were weighed out so that the ratio of $Nb/SiO_x$ was 55/45 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the condi-

4

tions, output power of 300 W, Ar flow rate of 17 sccm and gas pressure of 5.3 mTorr to 5.5 mTorr, a film of 100 nm in thickness was formed on a glazed alumina substrate of 3 inches in size.

Example 3

Powder of Nb with an average particle size of 3 $\mu$m and powder of silicon oxide fully dried with an average particle size of 1 $\mu$m were weighed out so that the ratio of Nb/SiO$_x$ was 45/55 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 300 W, Ar flow rate of 17 sccm and gas pressure of 5.3 mTorr to 5.5 mTorr, a film of 100 nm in thickness was formed on a glazed alumina substrate of 3 inches in size.

Example 4

Powder of Nb alloy containing 15 mol% of Ta with an average particle size of 3 $\mu$m (Nb∗) and powder of silicon oxide fully dried with an average particle size of 1 $\mu$m were weighed out so that the ratio of Nb∗/SiO$_x$ was 70/30 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, tantalum oxide, niobium silicide, tantalum silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 300 W, Ar flow rate of 17 sccm and gas pressure of 5.3 mTorr to 5.5 mTorr, a film of 100 nm in thickness was formed on a glazed alumina substrate of 3 inches in size.

Example 5

Powder of Nb alloy containing 35 mol% of Ta with an average particle size of 3 $\mu$m (Nb∗) and powder of silicon oxide fully dried with an average particle size of 1 $\mu$m were weighed out so that the ratio of Nb∗/SiO$_x$ was 70/30 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, tantalum oxide, niobium silicide, tantalum silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 6

Powder of Nb alloy containing 15 mol% of Fe with an average particle size of 3 $\mu$m (Nb∗) and powder of silicon oxide fully dried with an average particle size of 1 $\mu$m were weighed out so that the ratio of Nb∗/SiO$_x$ was 70/30 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, iron oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 7

Powder of Nb alloy containing 35 mol% of Fe with an average particle size of 3 μm (Nb∗) and powder of silicon oxide fully dried with an average particle size of 1 μm were weighed out so that the ratio of Nb∗/SiO$_x$ was 70/30 by mole ratio and mixed in a ball mill in a vacuum for 18 hours. Then the mixture was pressed by a vacuum hot press apparatus at 100 kg/cm$^2$ and subjected to reactive sintering at 1400°C for 1 hour to obtain the objective sintered body. The component contained in the sintered body was identified by X-ray microanalyzer analysis and X-ray diffraction analysis and the presence of niobium oxide, iron oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 8

The mixture powder of Nb$_5$Si$_3$ and Nb$_2$O$_5$ with an average particle size of 7 μm in the ratio of 2 : 1 by weight and powder of silicon oxide fully dried with an average particle size of 3 μm were weighed out so that the ratio of Nb in the sputtering target objected was 78 % by weight and mixed in a ball mill in an atmosphere of argon for 18 hours. Then the mixture was pressed by a vacuum hot press apparatus at 100 kg/cm$^2$ and subjected to sintering at 1500°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 9

The mixture powder of Nb$_5$Si$_3$ and Nb$_2$O$_5$ with an average particle size of 7 μm in the ratio of 2 : 1 by weight and powder of silicon oxide fully dried with an average particle size of 3 μm were weighed out so that the ratio of Nb in the sputtering target objected was 78 % by weight and mixed in a ball mill in an atmosphere of argon for 18 hours. Then the mixture was pressed by a vacuum hot press apparatus at 100 kg/cm$^2$ and subjected to sintering at 1600°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 10

The mixture powder of Nb$_5$Si$_3$ and Nb$_2$O$_5$ with an average particle size of 7 μm in the ratio of 10 : 3 by weight and powder of silicon oxide fully dried with an average particle size of 3 μm were weighed out so that the ratio of Nb in the sputtering target objected was 65.4 % by weight and mixed in a ball mill in an atmosphere of argon for 18 hours. Then the mixture was pressed by a vacuum hot press apparatus at 100 kg/cm$^2$ and subjected to sintering at 1500°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 11

The mixture powder of $Nb_5Si_3$ and $Nb_2O_5$ with an average particle size of 7 μm in the ratio of 10 : 3 by weight and powder of silicon oxide fully dried with an average particle size of 3 μm were weighed out so that the ratio of Nb in the sputtering target objected was 65.4 % by weight and mixed in a ball mill in an atmosphere of argon for 18 hours. Then the mixture was pressed by a vacuum hot press apparatus at 100 kg/cm² and subjected to sintering at 1600°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 12

The mixture powder of $Nb_5Si_3$ and $Nb_2O_5$ with an average particle size of 7 μm in the ratio of 10 : 9 by weight and powder of silicon oxide fully dried with an average particle size of 3 μm were weighed out so that the ratio of Nb in the sputtering target objected was 56 % by weight and mixed in a ball mill in an atmosphere of argon for 18 hours. Then the mixture was pressed by a vacuum hot press apparatus at 100 kg/cm² and subjected to sintering at 1500°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Example 13

The mixture powder of $Nb_5Si_3$ and $Nb_2O_5$ with an average particle size of 7 μm in the ratio of 10 : 9 by weight and powder of silicon oxide fully dried with an average particle size of 3 μm were weighed out so that the ratio of Nb in the sputtering target objected was 56 % by weight and mixed in a ball mill in an atmosphere of argon for 18 hours. Then the mixture was pressed by a vacuum hot press apparatus at 100 kg/cm² and subjected to sintering at 1600°C for 3.5 hours to obtain the objective sintered body. The component contained in the sintered body was identified by X-ray microanalyzer analysis and X-ray diffraction analysis and the presence of niobium oxide, niobium silicide and silicon oxide was confirmed. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

Comparative example 1

Powder of Ta with an average particle size of 3 μm and powder of silicon oxide fully dried with an average particle size of 1 μm were weighed out so that the ratio of $Ta/SiO_x$ was 70/30 by mole ratio and mixed in a ball mill in a vacuum for 18 hours. Then the mixture was pressed by a vacuum hot press apparatus at 100 kg/cm² and subjected to reactive sintering at 1400°C for 1 hour to obtain the objective sintered body. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

7

EP 0 471 080 B1

Comparative example 2

Powder of Ta with an average particle size of 3 μm and powder of silicon oxide fully dried with an average particle size of 1 μm were weighed out so that the ratio of Ta/SiO$_x$ was 45/55 by mole ratio and mixed in a ball mill in a vacuum for 18 hours. Then the mixture was pressed by a vacuum hot press apparatus at 100 kg/cm$^2$ and subjected to reactive sintering at 1500°C for 1 hour to obtain the objective sintered body. The surface of the sintered body was machined and grinded approximately 1 mm to obtain a sputtering target with a diameter of 5 inches and thickness of 5 mm.

Then, using the sputtering target obtained above, by high frequency magnetron sputtering at the conditions, output power of 200 W, Ar flow rate of 17 sccm and gas pressure of 5.3 mTorr to 5.5 mTorr, a film of 100 nm in thickness was formed on a glazed alumina substrate of 3 inches in size.

The specific resistance and fluctuation of sheet resistance of the thin films obtained in the examples and comparative examples were measured. The results were shown in Table 1. The fluctuation of sheet resistance was measured by the method and the formula mentioned before.

## Table 1

| | Fluctuation of sheet resistance (%) | Specific resistance ( μ Ω cm) |
|---|---|---|
| Example 1 | 5.4 | 2000 |
| Example 2 | 6.0 | 8500 |
| Example 3 | 6.3 | 80100 |
| Example 4 | 6.0 | 4300 |
| Example 5 | 6.2 | 4800 |
| Example 6 | 5.5 | 9800 |
| Example 7 | 5.0 | 15000 |
| Example 8 | 8.5 | 3000 |
| Example 9 | 8.0 | 2900 |
| Example 10 | 14.0 | 9500 |
| Example 11 | 13.5 | 9400 |
| Example 12 | 17.5 | 79100 |
| Example 13 | 16.2 | 76000 |
| Comparative Example 1 | 20.5 | 215 |
| Comparative Example 2 | 30.2 | 73000 |

8

As clearly shown in Table 1, in the case where the conventional target was used, the fluctuation of sheet resistance was remarkably large and the control of the resistance of film was difficult, while in the case where the sputtering target obtained by reactive sintering was used, the structure of the sputtering target was *densified and the stable film which exhibited extremely small fluctuation of sheet resistance could be obtained. Moreover, it is also found that in the case where the sputtering target obtained by sintering the powder mixture comprising silicon oxide, niobium oxide and niobium silicide was used, a film which exhibited less fluctuation of sheet resistance than that of a conventional film was obtained. Further, as shown in Table 1, the more the content of the metal becomes, the less the fluctuation of sheet resistance becomes. Even if an alloy containing Ta, Fe and the like was used, good stability was obtained.

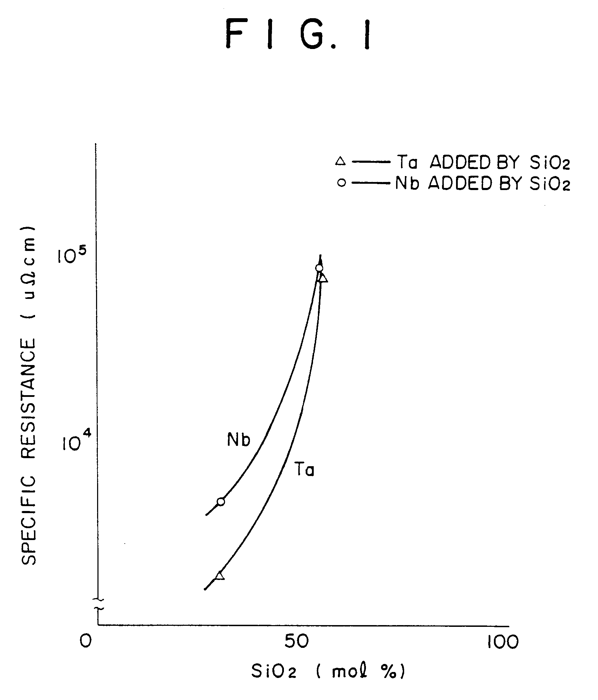

Based on the results of measuring specific resistance of thin films obtained in the examples and comparative examples, the relation between the specific resistance and the amount of $SiO_2$ in the Nb and Ta targets is shown in Fig. 1. As shown in Fig.1, in the both metal cases, as the content of $SiO_2$ increases, the specific resistance increased remarkably. However, the rate of the increase is larger in the case of Nb.

Table 2 shows the relation between the compositions of the targets obtained in the examples and comparative examples and the composition of the films obtained by sputtering the targets. From these results, it is found that by using the sputtering target of each example, a film having substantially the same composition of the sputtering target was obtained with good reproducibility. It is also found that even if an alloy containing Ta, Fe and the like was used, the characteristics of the film obtained was the almost same as those of the aforementioned films.

## Table 2

| | composition (component/$SiO_2$, mol%) | | |
|---|---|---|---|
| | component | target | film |
| Example 1 | Nb | 2.3 | 2.30 |
| Example 2 | Nb | 1.2 | 1.21 |
| Example 3 | Nb | 0.8 | 0.78 |
| Example 4 | Nb-15mol%Ta | 2.3 | 2.28 |
| Example 5 | Nb-35mol%Ta | 2.3 | 2.31 |
| Example 6 | Nb-15mol%Fe | 2.3 | 2.30 |
| Example 7 | Nb-35mol%Fe | 2.3 | 2.28 |
| Example 8 | Nb | 2.2 | 2.20 |
| Example 9 | Nb | 2.3 | 2.30 |
| Example 10 | Nb | 1.3 | 1.35 |
| Example 11 | Nb | 1.3 | 1.30 |
| Example 12 | Nb | 0.7 | 0.75 |
| Example 13 | Nb | 0.8 | 0.80 |
| Comparative Example 1 | Ta | 2.3 | 2.90 |
| Comparative Example 2 | Ta | 0.8 | 1.06 |

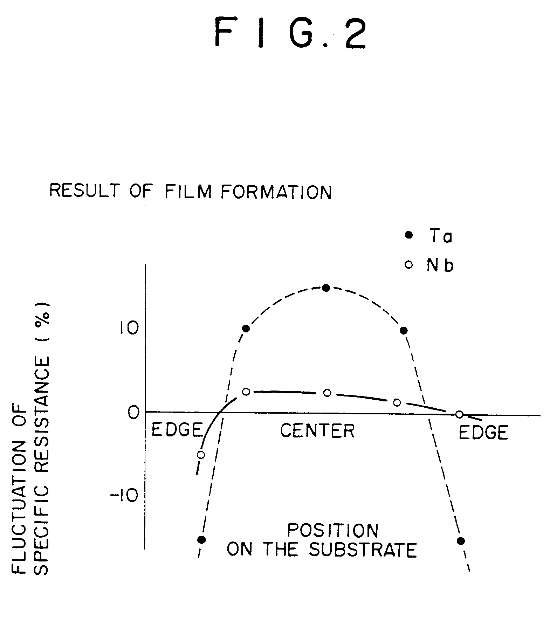

Furthermore, a sputtering target of 121 mm x 378 mm x 7.5 mm having the same composition as that of example 3 was produced and a glazed alumina substrate (A4 size) was moved reciprocally in the direction perpendicular to the long side of the target to form a film of 100 nm in thickness. The film resistance thereof was measured. As a comparison, a target of 121 mm x 378 mm x 7.5 mm having the same composition as that of comparative example 2 was prepared and the film resistance was measured in the same manner as before. The results obtained were shown in Fig. 2. From the figure, it is clearly shown that the fluctuation of a substrate in the sputtering target of the present invention was improved remarkably, compared with that in the conventional one.

Now, embodiments of a thermal printer head according to the present invention will be disclosed as follow.

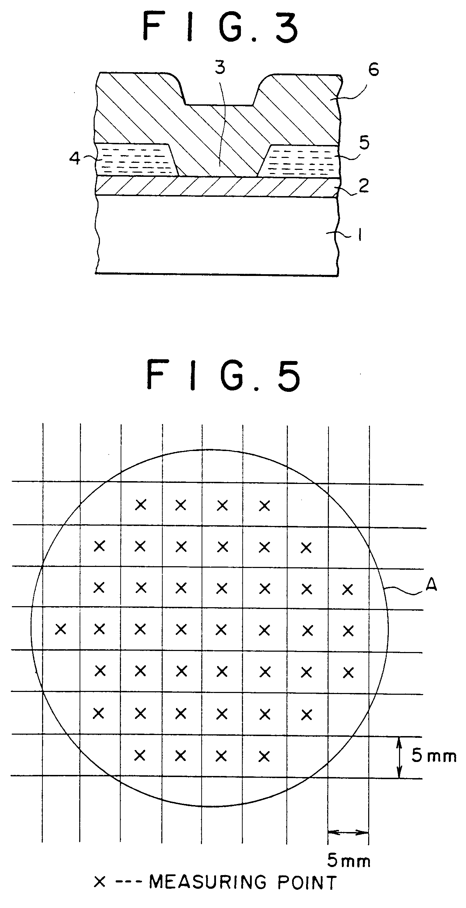

The thermal printer head used in the embodiment will be described referring to Fig. 3. In the figure, the numeral 1 shows an insulating substrate such as a ceramic substrate and metal substrate coated by an insulating layer on the surface. On the insulating substrate 1, a heat generating resistor layer 2 was formed and the heat generating resistor layer 2 was patterned to constitute a group of heat generating resistors. On each heat generating resistor 2, a common electrode 4 and an individual electrode 5 made of aluminum and so forth were arranged so that an opening as a heat generating part 3 was formed. A protection layer 6 with thickness of approximately 100 nm to 10 μm was formed so as to cover at least the heat generating part 3. The preferable thickness of the protection layer is 1 μm to 5 μm and more preferably 3 μm to 4 μm.

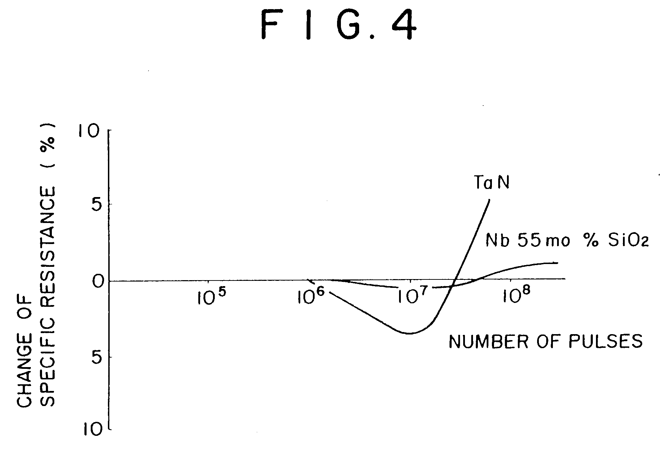

First, the glazed alumina substrate where a film resistor was deposited according to example 3, was used as an insulating substrate 1 of a thermal printer head as above. At the same time, a film resistor was used as a heat generating resistor 2. After the film resistor was patterned, aluminum electrodes 4 and 5 were arranged on each heat generating resistor 2 and then a protection layer was deposited to obtain a thermal printer head. Heating pulses with pulse width of 0.3 sec and the cycle of 5 msec were applied to the thermal printer head obtained above. At this time, the change percentage of the resistance was shown in Fig. 4. For comparison, the results obtained on a thermal printer head using a conventional TaN resistor film were shown together with the above.

As clearly shown from the results, the thermal printer head of the present invention exhibits smaller fluctuation of the resistance caused by heating pulses and more excellent heat resistance property, compared with the thermal printer head using the TaN resistor film.

In addition, in the present invention, if an alloy comprising Nb and Ta contains a small amount of Fe or an alloy comprising Nb and Fe contains a small amount of Ta, the similar results are obtained.

As clearly shown in the above examples, by using the sputtering target of the present invention, high resistance resistor film with constant value of resistance and the constant film composition can be formed with high reproducibility. In the case where Nb was used as a target material, sputter rate is more uniform, compared with the case where Ta was used. Thus, the film formed by using the target of Nb was improved in the uniformity. Furthermore, since the target of the present invention is not formed by the reactive sputtering method, any delicate control of gas is not required and the manufacturing method is simplified. The thermal printer head of the present invention is a thin film type thermal printer head, which is provided with the above film resistor of the present invention with high specific resistance, high heat stability, and high heat resistance as a heat generator. Thus, this thermal printer head can satisfy the requirements for high speed operation and high temperature resistance, and a thermal printer head with excellent printing characteristics is obtained due to uniformity of resistance in head. The thermal head printer of the present invention is very valuable from the view of industrial applications.

As mentioned above, the film resistor formed by using the sputtering target of the present invention is valuable for the use as a heat generator of a thermal printer head and so forth because the film composition and the resistance thereof are constant and the specific resistance is high. Further, the thermal printer head of the present invention is useful as a recording device where miniaturization and high performances are required because the thermal printer head enables a high speed operation and high heat resistance easily and satisfies high quality of a printed image.

## Claims

1. A sputtering target comprising a sintered body of an oxide containing niobium, a silicide containing niobium and silicon oxide substantially for the rest.

2. A sputtering target as claimed in claim 1, wherein said sputtering target is formed by reactive sintering a powdery niobium or a powdery niobium alloy containing silicon oxide in the range of 15 to 70 mol % by mole ratio.

3. A sputtering target as claimed in claim 1, wherein said sputtering target is formed by sintering the mixture comprising powdery oxide of niobium or niobium alloy, powdery silicide of niobium or niobium alloy and powdery silicon oxide substantially for the rest.

4. A sputtering target as claimed in claim 2 and 3, wherein said niobium alloy comprises niobium, and tantalum and/or iron.

5. A film resistor formed by sputtering using a sintered sputtering target comprising an oxide containing niobium, a silicide containing niobium and silicon oxide substantially for the rest.

6. A film resistor as claimed in claim 5, wherein said sputtering target is formed by reactive sintering powdery niobium or powdery niobium alloy containing silicon oxide in the range of 15 mole % to 70 mole % by mole ratio.

7. A film resistor as claimed in claim 5, wherein said sputtering target is formed by reactive sintering the mixture comprising powdery oxide of niobium or niobium alloy, powdery silicide of niobium or niobium alloy and powdery silicon oxide substantially for the rest.

8. A film resistor as claimed in claim 6 or 7, wherein said niobium alloy comprises niobium, tantalum and/or iron.

9. A film resistor as claimed in claim 5, wherein the specific resistance of said film resistor is in the range of $10^2$ $\mu\Omega$ cm to $10^6$ $\mu\Omega$cm.

10. A film resistor as claimed in claim 5, wherein the fluctuation of sheet resistance of said film resistor is 20 % or less.

11. A film resistor as claimed in claim 5, wherein said film resistor has film thickness of 5 nm to 3000 nm.

12. A thermal printer head comprising an insulating substrate, a plurality of heat generating resistors disposed thereon and an electrode connected to the heat generating resistors, wherein said heat generating resistor comprises a film resistor formed by sputtering using a sintered sputtering target comprising an oxide containing niobium, a silicide containing niobium and silicon oxide substantially for the rest.

13. A thermal printer head as claimed in claim 12, wherein said heat generating resistor comprises a film resistor formed by sputtering using a sintered sputtering target obtained by reactive sintering powdery niobium or powdery niobium alloy containing silicon oxide in the range of 15 mole % to 70 mole % by mole ratio.

14. A thermal printer head as claimed in claim 12, wherein said heat generating resistor comprises a film resistor formed by sputtering using a sintered sputtering target obtained by sintering the mixture of powdery oxide of niobium or niobium alloy, silicide of niobium or niobium alloy and powdery silicon oxide substantially for the rest.

15. A thermal printer head as claimed in claim 13 or 14, wherein said niobium alloy contains niobium, tantalum and/or iron.

16. A thermal printer head as claimed in claim 12, wherein the specific resistance of said heat generating resistor is in the range of $10^2$ $\mu\Omega$cm to $10^6$ $\mu\Omega$cm.

17. A thermal printer head as claimed in claim 12, wherein fluctuation of the sheet resistance of said heat generating resistor is 20 % or less.

18. A thermal printer head as claimed in claimed in claim 12, wherein said heat generating resistor has a protection film with thickness of 100 nm to 10 $\mu$m.

19. A method of manufacturing a sputtering target as claimed in claim 1 comprising the step of:
reactive sintering a powdery niobium or a powdery niobium alloy containing silicon oxide in the range of 15 to 70 mol % by mol ratio.

20. A method of manufacturing a sputtering target comprising the step of:
sintering a mixture of powdery oxide of niobium or niobium alloy, powdery silicide of niobium or niobium alloy and powdery silicon oxide substantially for the rest.

21. A method of manufacturing a film resistor, said method comprising the step of:
sputtering a sintered sputtering target, said sintered sputtering target comprising an oxide containing niobium, a silicide containing niobium and silicon oxide substantially for the rest.

22. A method as claimed by claim 21, wherein said method further comprises forming said sputtering target by reactive sintering powdery niobium or powdery niobium alloy containing silicon oxide in the range of 15 mol % to 70 mol % by mol ratio.

23. A method as claimed by claim 21, wherein said method further comprises reactive sintering the mixture comprising powdery oxide of niobium or niobium alloy, powdery silicide of niobium or niobium alloy and powdery silicon oxide substantially for the rest.

24. A method of manufacturing a thermal printer head comprising the steps of:
    disposing a plurality of heat generating resistors on an insulating substrate;
    connecting an electrode to the heat generating resistors, wherein said heat generating resistors are formed by sputtering a sintered sputtering target, said sintered sputtering target comprising an oxide containing niobium, a silicide containing niobium and silicon oxide substantially for the rest.

25. A method as claimed by claim 24, wherein said method further comprises forming said sputtering target by reactive sintering powdery niobium or powdery niobium alloy containing silicon oxide in the range of 15 mol % to 70 mol % by mol ratio.

26. A method as claimed by claim 24, wherein said method further comprises reactive sintering the mixture comprising powdery oxide of niobium or niobium alloy, powdery silicide of niobium or niobium alloy and powdery silicon oxide substantially for the rest.


**Patentansprüche**

1. Zerstäubungstarget, das einen Sinterkörper aus einem oxidhaltigen Niob, einem silizidhaltigen Niob und Siliziumoxid, das im wesentlichen die restlichen Prozentwerte sind, aufweist.

2. Zerstäubungstarget nach Anspruch 1, bei dem das Zerstäubungstarget durch das reaktionsfähige Sintern eines pulverigen Niobs oder einer pulverigen Nioblegierung, die Siliziumoxid im Bereich von 15 bis 70 mol-% nach dem Molverhältnis enthalten, gebildet wird.

3. Zerstäubungstarget nach Anspruch 1, bei dem das Zerstäubungstarget durch Sintern der Mischung gebildet wird, die pulveriges Oxid des Niobs oder der Nioblegierung, pulveriges Silizid des Niobs oder der Nioblegierung und pulveriges Siliziumoxid, das im wesentlichen die restlichen Prozentwerte sind, aufweist.

4. Zerstäubungstarget nach Anspruch 2 und 3, bei dem die Nioblegierung Niob und Tantal und/oder Eisen aufweist.

5. Filmwiderstand, der durch Zerstäubung bei Benutzung eines gesinterten Zerstäubungstargets gebildet wird, das ein oxidhaltiges Niob, ein silizidhaltiges Niob und Siliziumoxid, das im wesentlichen die restlichen Prozentwerte sind, aufweist.

6. Filmwiderstand nach Anspruch 5, bei dem das Zerstäubungstarget durch reaktionsfähiges Sintern von pulverigem Niob oder pulveriger Nioblegierung, die Siliziumoxid im Bereich von 15 bis 70 mol-% nach dem Molverhältnis enthalten, gebildet wird.

7. Filmwiderstand nach Anspruch 5, bei dem das Zerstäubungstarget durch reaktionsfähiges Sintern der Mischung gebildet wird, die pulveriges Oxid des Niobs oder der Nioblegierung, pulveriges Silizid des Niobs oder der Nioblegierung und pulveriges Siliziumoxid, das im wesentlichen die restlichen Prozentwerte sind, aufweist.

8. Filmwiderstand nach Anspruch 6 oder 7, bei dem die Nioblegierung Niob, Tantal und/oder Eisen aufweist.

9. Filmwiderstand nach Anspruch 5, bei dem der spezifische elektrische Widerstand des Filmwiderstandes im Bereich von $10^2$ $\mu\Omega$cm bis $10^6$ $\mu\Omega$cm liegt.

10. Filmwiderstand nach Anspruch 5, bei dem die Schwankung des Schichtwiderstandes des Filmwiderstandes 20% oder weniger beträgt.

11. Filmwiderstand nach Anspruch 5, bei dem der Filmwiderstand eine Filmdicke von 5 nm bis 3000 nm aufweist.

12. Thermodruckkopf, der aufweist: ein isolierendes Substrat; eine Vielzahl von wärmeerzeugenden Widerständen, die darauf angeordnet sind; und eine Elektrode, die mit den wärmeerzeugenden Widerständen verbunden ist, wobei der wärmeerzeugende Widerstand einen Filmwiderstand aufweist, der durch Zerstäubung bei Benutzung eines gesinterten Zerstäubungstargets gebildet wird, das ein oxidhaltiges Niob, ein silizidhaltiges Niob und Siliziumoxid, das im wesentlichen die restlichen Prozentwerte sind, aufweist.

13. Thermodruckkopf nach Anspruch 12, bei dem der wärmeerzeugende Widerstand einen Filmwiderstand aufweist, der durch Zerstäubung bei Benutzung eines gesinterten Zerstäubungstargets gebildet wird, das durch reaktionsfähiges Sintern von pulverigem Niob oder pulveriger Nioblegierung, die Siliziumoxid im Bereich von 15 bis 70 mol-% nach dem Molverhältnis enthalten, erhalten wird.

14. Thermodruckkopf nach Anspruch 12, bei dem der wärmeerzeugende Widerstand einen Filmwiderstand aufweist, der durch Zerstäubung bei Benutzung eines gesinterten Zerstäubungstargets gebildet wird, das durch Sintern der Mischung von pulverigem Oxid des Niobs oder der Nioblegierung, Silizid des Niobs oder der Nioblegierung und pulverigem Siliziumoxid, das im wesentlichen die restlichen Prozentwerte sind, erhalten wird.

15. Thermodruckkopf nach Anspruch 13 oder 14, bei dem die Nioblegierung Niob, Tantal und/oder Eisen enthält.

16. Thermodruckkopf nach Anspruch 12, bei dem der spezifische elektrische Widerstand des wärmeerzeugenden Widerstandes im Bereich von $10^2$ $\mu\Omega$cm bis $10^6$ $\mu\Omega$cm liegt.

17. Thermodruckkopf nach Anspruch 12, bei dem die Schwankung des Schichtwiderstandes des wärmeerzeugenden Widerstandes 20% oder weniger beträgt.

18. Thermodruckkopf nach Anspruch 12, bei dem der wärmeerzeugende Widerstand einen Schutzfilm mit einer Dicke von 100 nm bis 10 $\mu$m aufweist.

19. Verfahren für die Herstellung eines Zerstäubungstargets nach Anspruch 1, das den folgenden Schritt aufweist:
   reaktionsfähiges Sintern eines pulverigen Niobs oder einer pulverigen Nioblegierung, die Siliziumoxid im Bereich von 15 bis 70 mol-% nach dem Molverhältnis enthalten.

20. Verfahren für die Herstellung eines Zerstäubungstargets, das den folgenden Schritt aufweist:
   Sintern einer Mischung des pulverigen Oxids des Niobs oder der Nioblegierung, des pulverigen Silizids des Niobs oder der Nioblegierung und des pulverigen Siliziumoxids, das im wesentlichen die restlichen Prozentwerte sind.

21. Verfahren für die Herstellung eines Filmwiderstandes, das den folgenden Schritt aufweist:
   Zerstäubung eines gesinterten Zerstäubungstargets, dadurch gekennzeichnet, daß das gesinterte Zerstäubungstarget ein oxidhaltiges Niob, ein silizidhaltiges Niob und Siliziumoxid, das im wesentlichen die restlichen Prozentwerte sind, aufweist.

22. Verfahren nach Anspruch 21, dadurch gekennzeichnet, daß das Verfahren außerdem die Bildung des Zerstäubungstargets durch reaktionsfähiges Sintern von pulverigem Niob oder einer pulverigen Nioblegierung, die Siliziumoxid im Bereich von 15 bis 70 mol-% nach dem Molverhältnis enthalten, aufweist.

23. Verfahren nach Anspruch 21, dadurch gekennzeichnet, daß das Verfahren außerdem das reaktionsfähige Sintern der Mischung aufweist, die pulveriges Oxid des Niobs oder der Nioblegierung, pulveriges Silizid des Niobs oder der Nioblegierung und pulveriges Siliziumoxid, das im wesentlichen die restlichen Prozentwerte sind, aufweist.

24. Verfahren für die Herstellung eines Thermodruckkopfes, das die folgenden Schritte aufweist:
   Anordnen einer Vielzahl von wärmeerzeugenden Widerständen auf einem isolierenden Substrat;

Verbinden einer Elektrode mit den wärmeerzeugenden Widerständen, wobei die wärmeerzeugenden Widerstände durch Zerstäubung eines gesinterten Zerstäubungstargets gebildet werden, und wobei das gesinterte Zerstäubungstarget ein oxidhaltiges Niob, ein silizidhaltiges Niob und Siliziumoxid, das im wesentlichen die restlichen Prozentwerte sind, aufweist.

25. Verfahren nach Anspruch 24, dadurch gekennzeichnet, daß das Verfahren außerdem die Bildung des Zerstäubungstargets durch reaktionsfähiges Sintern von pulverigem Niob oder einer pulverigen Nioblegierung, die Siliziumoxid im Bereich von 15 bis 70 mol-% nach dem Molverhältnis enthalten, aufweist.

26. Verfahren nach Anspruch 24, dadurch gekennzeichnet, daß das Verfahren außerdem das reaktionsfähige Sintern der Mischung aufweist, die pulveriges Oxid des Niobs oder einer Nioblegierung, pulveriges Silizid des Niobs oder einer Nioblegierung und pulveriges Siliziumoxid, das im wesentlichen die restlichen Prozentwerte sind, aufweist.

## Revendications

1. Cible de pulvérisation comprenant un corps fritté en un oxyde contenant du niobium, en un siliciure contenant du niobium et, pour sensiblement le reste, en oxyde de silicium.

2. Cible de pulvérisation selon la revendication 1, dans laquelle une cible de pulvérisation est formée au moyen d'un frittage réactif d'un niobium pulvérulent ou d'un alliage de niobium pulvérulent contenant de l'oxyde de silicium dans la plage de 15 à 70% (rapport molaire).

3. Cible de pulvérisation selon la revendication 1, dans laquelle une cible de pulvérisation est formée en frittant le mélange comprenant de l'oxyde de niobium ou d'alliage de niobium pulvérulent, du siliciure de niobium ou d'alliage de niobium pulvérulent et, pour sensiblement le reste, de l'oxyde de silicium pulvérulent.

4. Cible de pulvérisation selon les revendications 2 et 3, dans laquelle ledit alliage de niobium comprend du niobium et du tantale et/ou du fer.

5. Résistance en film formée par pulvérisation en utilisant une cible de pulvérisation frittée comprenant un oxyde contenant du niobium, un siliciure contenant du niobium et, pour sensiblement le reste, de l'oxyde de silicium.

6. Résistance en film selon la revendication 5, dans laquelle ladite cible de pulvérisation est formée au moyen d'un frittage réactif de niobium pulvérulent ou d'alliage de niobium pulvérulent contenant de l'oxyde de silicium dans la plage de 15 à 70% (rapport molaire).

7. Résistance en film selon la revendication 5, dans laquelle ladite cible de pulvérisation est formée par frittage réactif d'un mélange comprenant de l'oxyde de niobium ou d'alliage de niobium pulvérulent, du siliciure de niobium ou d'alliage de niobium pulvérulent et, pour sensiblement le reste, de l'oxyde de silicium pulvérulent.

8. Résistance en film selon la revendication 6 ou 7, dans laquelle ledit alliage de niobium comprend du niobium, du tantale et/ou du fer.

9. Résistance en film selon la revendication 5, dans laquelle la résistivité de ladite résistance en film est dans la plage de $10^2$ $\mu\Omega$cm à $10^6$ $\mu\Omega$cm.

10. Résistance en film selon la revendication 5, dans laquelle la fluctuation de la valeur de résistance par carré de ladite résistance en film est de 20% ou moins.

11. Résistance en film selon la revendication 5, dans laquelle ladite résistance en film présente une épaisseur de film de 5 nm à 300 nm.

12. Tête d'imprimante thermique comprenant un substrat isolant, une pluralité de résistances de génération de chaleur disposées dessus et une électrode connectée aux résistances de génération de chaleur, dans laquelle ladite résistance de génération de chaleur comprend une résistance en film formée par pulvérisation en utilisant une cible de pulvérisation frittée comprenant un oxyde contenant du niobium, un siliciure contenant du niobium et, sensiblement pour le reste, de l'oxyde de silicium.

13. Tête d'imprimante thermique selon la revendication 12, dans laquelle ladite résistance de génération de chaleur comprend une résistance en film formée par pulvérisation en utilisant une cible de pulvérisation frittée obtenue par frittage réactif de niobium pulvérulent ou d'alliage de niobium pulvérulent contenant de l'oxyde de silicium dans la plage de 15 à 70% (rapport molaire).

14. Tête d'imprimante thermique selon la revendication 12, dans laquelle ladite résistance de génération de chaleur comprend une résistance en film formée par pulvérisation en utilisant une cible de pulvérisation frittée obtenue par frittage du mélange d'oxyde de niobium ou d'alliage de niobium pulvérulent, de siliciure de niobium ou d'alliage de niobium et, sensiblement pour le reste, d'oxyde de silicium pulvérulent.

15. Tête d'imprimante thermique selon la revendication 13 ou 14, dans laquelle ledit alliage de niobium contient du niobium, du tantale et/ou du fer.

16. Tête d'imprimante thermique selon la revendication 12, dans laquelle la résistivité de ladite résistance de génération de chaleur est dans la plage de $10^2$ $\mu\Omega$cm à $10^6$ $\mu\Omega$cm.

17. Tête d'imprimante thermique selon la revendication 12, dans laquelle la fluctuation de la résistance par carré de ladite résistance de génération de chaleur est de 20% ou moins.

18. Tête d'imprimante thermique selon la revendication 12, dans laquelle ladite résistance de génération de chaleur comporte un film de protection présentant une épaisseur de 100 nm à 10 $\mu$m.

19. Procédé de fabrication d'une cible de pulvérisation selon la revendication 1, comprenant l'étape de:
    frittage réactif d'un niobium pulvérulent ou d'un alliage de niobium pulvérulent contenant de l'oxyde de silicium dans la plage de 15 à 70% (rapport molaire).

20. Procédé de fabrication d'une cible de pulvérisation, comprenant l'étape de:
    frittage d'un mélange d'oxyde de niobium ou d'alliage de niobium pulvérulent, de siliciure de niobium ou d'alliage de niobium pulvérulent et, sensiblement pour le reste, d'oxyde de silicium pulvérulent.

21. Procédé de fabrication d'une résistance en film, ledit procédé comprenant l'étape de:
    pulvérisation d'une cible de pulvérisation frittée, ladite cible de pulvérisation frittée comprenant un oxyde contenant du niobium, un siliciure contenant du niobium et, sensiblement pour le reste, de l'oxyde de silicium.

22. Procédé selon la revendication 21, dans lequel ledit procédé comprend en outre la formation de ladite cible de pulvérisation par frittage réactif de niobium pulvérulent ou d'alliage de niobium pulvérulent contenant de l'oxyde de silicium dans la plage de 15% à 70% (rapport molaire).

23. Procédé selon la revendication 21, dans lequel ledit procédé comprend en outre le frittage réactif du mélange comprenant de l'oxyde de niobium pulvérulent ou d'alliage de niobium pulvérulent, du siliciure de niobium ou d'alliage de niobium pulvérulent et, sensiblement pour le reste, de l'oxyde de silicium pulvérulent.

24. Procédé de fabrication d'une tête d'imprimante thermique comprenant les étapes de:
    disposition d'une pluralité de résistances de génération de chaleur sur un substrat isolant;
    connexion d'une électrode aux résistances de génération de chaleur, lesdites résistances de génération de chaleur étant formées par pulvérisation d'une cible de pulvérisation frittée, ladite cible de pulvérisation frittée comprenant un oxyde contenant du niobium, un siliciure contenant du niobium et, sensiblement pour le reste, de l'oxyde de silicium.

25. Procédé selon la revendication 24, dans lequel ledit procédé comprend en outre la formation de ladite cible de pulvérisation par un frittage réactif de niobium pulvérulent ou d'alliage de niobium pulvérulent contenant de l'oxyde de silicium dans la plage de 15% à 70% (rapport molaire).

26. Procédé selon la revendication 24, dans lequel ledit procédé comprend en outre le frittage réactif du mélange comprenant de l'oxyde de niobium ou d'alliage de niobium pulvérulent. du siliciure de niobium ou d'alliage de niobium pulvérulent et, sensiblement pour le reste, de l'oxyde de silicium pulvérulent.

# F I G. I

# F I G. 2

RESULT OF FILM FORMATION

# F I G. 3

# F I G. 5

5 mm

5 mm

× --- MEASURING POINT

FIG. 4